# EUROPÄISCHE PATENTSCHRIFT

(11) **EP 1 825 968 B1**
(45) Veröffentlichungstag und Bekanntmachung des Hinweises auf die Patenterteilung: **22.12.2010**
(21) Anmeldenummer: 06127388.4
(22) Anmeldetag: 31.12.2006
(51) Int. Cl.: B25J 9/04, F16C 11/06, H01J 37/20, F16D 3/18

(54) **Kippbare Seilantriebseinheit für Kryomanipulatoren**
Tilting unit driven by cables for cryomanipulators
Unité basculante entraînée par câbles pour cryomanipulateurs

(30) Priorität: 02.01.2006 DE 102006001557
(43) Veröffentlichungstag der Anmeldung: 29.08.2007
(73) Patentinhaber: Leibniz-Institut für Festkörper- und Werkstoffforschung Dresden e.V., 01069 Dresden (DE)
(72) Erfinder: Möhler, Klaus, 01217 Dresden (DE)
(74) Vertreter: Rauschenbach, Marion

(56) Entgegenhaltungen:
- DE-B- 1 196 023
- DE-U1- 8 314 385
- JP-A- 2005 230 949
- US-A- 5 007 880
- US-A- 5 878 492

## Beschreibung

Die Erfindung bezieht sich auf die Gebiete des Maschinenbaus und der Forschungstechnik und betrifft eine kippbare Seilantriebseinheit für Kryomanipulatoren, die in Apparaturen und Kammern zum Einsatz kommen können, in denen Werkstoffproben zu untersuchen, zu bearbeiten oder zu beschichten sind.

Es sind Manipulatoren zur Einstellung der Probenposition in Vakuumkammern bekannt. Bei einem dieser Manipulatoren ist es möglich, die Position einer innerhalb der Kammer befindlichen Probe in zwei Bewegungsrichtungen einzustellen (Katalog Vakuum Komponenten der Firma Caburn-MDC, East Sussex, GB, 1997/98, S. 375). Hierbei kann die senkrecht angeordnete scheibenförmige Probe um ihre senkrechte Achse (polare Drehung) und um ihre waagerechte Achse (Azimutdrehung) gedreht werden. Die Probe ist auf einer Probenträgeraufnahme befestigt, die entsprechend betätigt werden kann. Für die Betätigung der Probenträgeraufnahme zur Azimutdrehung der Probe dient ein Zahnradgetriebe, das über eine Welle von einem Stellmotor angetrieben wird. Die Welle befindet sich dabei in einem in die Vakuum-Apparatur ragenden Führungsrohr, das zur Realisierung der polaren Drehung der Probe mit einer an der Apparatur vorhandenen Stelleinrichtung axial gedreht werden kann.

Nachteilig bei dieser Lösung ist, dass ein Verdrehen und Verkippen der Probenträgeraufnahme nicht möglich ist.

Bekannt sind Gelenkwellen verschiedenster Ausführung, meist in der Ausführung Welle mit Kugelende und Welle mit Klauenteil, die meist mit zwei um 90° versetzten Mitnehmerstiften, mit oder ohne Nutensteine, miteinander verknüpft sind und dadurch eine Verkippung während der eingeleiteten Drehbewegung zulassen, siehe z.B. JP-A-2005 230 949.
Nachteilig ist hierbei, dass neben der meist robusten Bauweise, infolge hoher Belastungen, eine Hohlwellengestaltung zwangsläufig eine Vergrößerung der Außenkontur der Bauelemente unumgänglich macht. Des Weiteren wird im Falle des Verkippens die Drehbewegung nicht winkelproportional übertragen, sondern in Abhängigkeit von der Kippwinkelgröße eine regelmäßige, sinusförmige Winkelübertragungsschwankung erzeugt, was ebenfalls nachteilig ist.

Bekannt sind weiterhin Gleichlaufgelenkwellen zur Übertragung kontinuierlicher und großer Drehmomente (Fahrzeugbau). Hier wird zwar durch die in Übertragungsnuten umlaufenden, meist kugeligen Körper, eine winkelproportionale Drehbewegung erreicht, verlangt aber infolge der vielen Bewegungsübertragungskörper (Kugeln, Führungsnuten, Fassungen u.a.) erhebliche Baugröße, was durch eine, wie oben genannte Hohlwellengestaltung noch verstärkt werden würde.

Aus der DE-U-83 14 385 ist eine Zahnkupplung zwischen einem Außen- und einem Innenring bekannt, bei der die Zähne für eine Winkelbeweglichkeit ballig ausgeführt sind.

Der Erfindung liegt die Aufgabe zugrunde, eine kippbare Seilantriebseinheit für Kryomanipulatoren anzugeben, wodurch ein Abrutschen des Seiles vom Seilrad bei Einleitung von anderen Bewegungsrichtungen als die des Seiles verringert wird.

Die Aufgabe wird durch die Vorrichtung gemäß Anspruch 1 gelöst. Weiterbildungen sind Gegenstand der Unteransprüche.

Die erfindungsgemäße kippbare Seilantriebseinheit für Manipulatoren besteht aus mindestens zwei Seilrädern. Davon besteht wiederum mindestens ein Seilrad aus einem Außenring, der eine Innenverzahnung aufweist, und aus einem Innenring, der mit einer Welle fest verbunden ist und eine Außenverzahnung aufweist, die in die Innenverzahnung des Außenrings passt. Die Aussparungen der Innenverzahnung des Außenrings weisen über die gesamte Höhe des Außenringes einen im wesentlichen unveränderten rechteckigen Querschnitt auf und die auf dem Innenring hervorstehenden Zähne der Außenverzahnung des Innenringes passen mit ihrem größten Querschnitt mindestens in die Aussparungen der Innenverzahnung des Außenringes. Die Zähne der Außenverzahnung des Innenringes weisen über die Höhe des Innenringes eine veränderliche Breite auf, die in der Mitte der Höhe des Innenringes am größten ist und höchstens der maximalen Breite der Aussparungen im Außenring entspricht. Die Breite der Zähne wird dabei mit der Entfernung von der Mitte der Höhe geringer und der Winkel der Zahnflanken zwischen maximaler und minimaler Breite der Zähne beträgt maximal 30 °.

Mit der erfindungsgemäßen Lösung wird es möglich, Seilantriebseinheiten für Kryomanipulatoren kippbar und winkelproportional kippbar zu gestalten. Dies ist insbesondere von Vorteil, da die Seilantriebe gegen auslenkende Bewegungen außerhalb des Seilverlaufes anfällig sind. Da dies bei Kryomanipulatoren auftritt, war eine Lösung zur Abtrennung dieser Bewegung vom eigentlichen Seilantrieb gewünscht, ohne die Funktion des Seilantriebes zu verändern oder zu verschlechtern. Mit der erfindungsgemäßen Lösung kann über die mit dem Innenring fest verbundene Hohlwelle die über den Seilantrieb erfolgte Bewegung nun in einem Winkel von maximal 60 ° gegenüber der gemeinsamen Achse von Innen- und Außenring gekippt werden, ohne dass die Funktion des Seilantriebes selbst beeinträchtigt wird. Die Kippung kann dabei jeweils maximal 30 ° in beiden Richtungen von der gemeinsamen Achse von Innen- und Außenring betragen, da sonst für die erfindungsgemäße Ausführung der Seilantriebseinheit eine sichere Übertragung der Bewegung nicht mehr gewährleistet ist.

Diese Lösung ist auch von besonderem Vorteil für Kryomanipulatoren, da die Bauteile derartiger Manipulatoren oft nur Abmessungen im cm-Bereich aufweisen und zulassen, die aber aufgrund der jeweiligen Arbeitsbedingungen in den Behältern, in denen die Manipulatoren angeordnet sind, über die gesamte Laufzeit sicher arbeiten müssen. Dementsprechend ist die Auswahl der Bauteile derartiger Manipulatoren von großer Bedeutung.

Ein weiterer Vorteil der erfindungsgemäßen Lösung ist, dass nunmehr keine unlinearen Rückwirkungen des Verkippungswinkels eines Seilrades auf die anderen Achsen der Seilantriebseinheit mehr erfolgt und damit beispielsweise die achsgenaue und winkelgenaue Bestimmung der Lage eines Kristalls oder einer anderen Probe möglich wird.
Des Weiteren gestattet die vorgeschlagene Lösung zur Kühlung von Probe und deren Halterung ein flexibles Metallseil (z.B. Kupferlitze) in einer größtmöglichen Bohrung des Innenringes wärmeisoliert mittig heranzuführen.

Nachfolgend wird die Erfindung an einem Ausführungsbeispiel näher erläutert. Dabei stellen die beigefügten Zeichnungen nur Prinzipskizzen dar und geben keinen Aufschluss über tatsächliche Abmessungen.

Dabei zeigt:

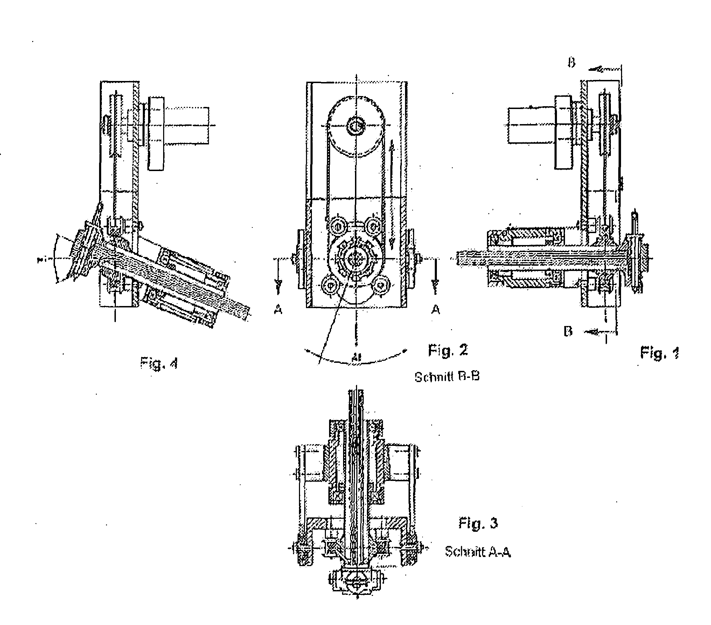

- Fig. 1: eine Seitenansicht der erfindungsgemäßen Seilantriebseinheit,
- Fig. 2: Schnitt B-B der Seitenansicht
- Fig. 3: Schnitt A-A von Fig. 2
- Fig. 4: die erfindungsgemäße Seilantriebseinheit in einer der maximalen Auslenkungspositionen

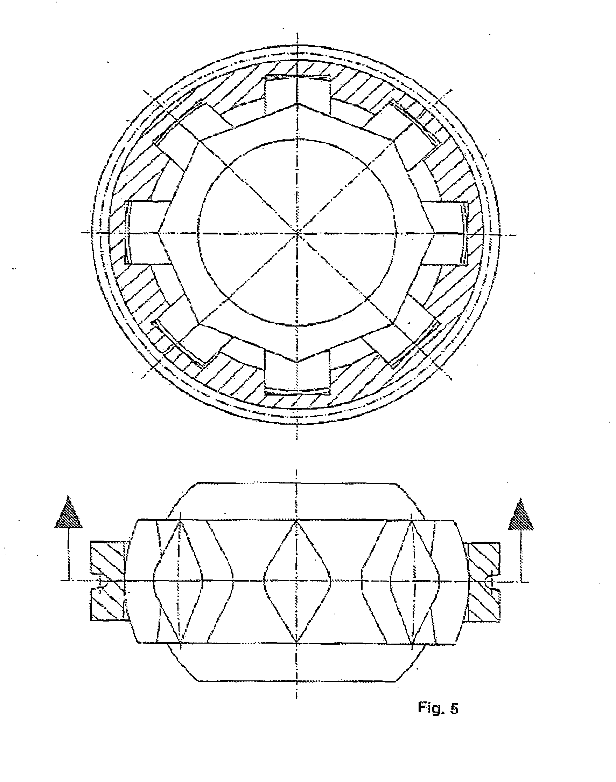

- Fig. 5: Seitenansicht und Querschnitt eines erfindungsgemäßen Seilrades mit Verzahnung

### Beispiel

Ein Seilantrieb besteht aus zwei Seilrädern, deren maximale Durchmesser jeweils 20 mm und deren maximale Höhe jeweils 4,00 mm betragen. Ein Seilrad ist radial in zwei Teile geteilt. Der Außenring hat einen Innendurchmesser von 15 mm und 8 über dem Umfang des Innendurchmessers gleichmäßig verteilte im Querschnitt rechteckige Aussparungen von 3,14 mm Breite und 1,00 mm Tiefe. Der Innenring ist in seiner Achse mit einer Hohlwelle fest verbunden. Auf der Außenseite des Innenringes sind über den Umfang des Innenrings gleichmäßig 8 hervorstehende Zähne verteilt, die in ihrer Anordnung den Aussparungen im Außenring entsprechen und in sie hineinpassen. Alle 8 Zähne erstrecken sich über die gesamte Höhe des Innenringes und sind in der Mitte der Höhe des Innenringes jeweils 3,14 mm breit und an den jeweiligen Außenseiten zusammenlaufend und mittig abgerundet. Von der Mitte der Höhe des Innenringes aus werden alle Zähne zu den Außenseiten kontinuierlich schmaler, wobei der Winkel der Zahnflanken zwischen der Mitte der Höhe des Innenringes und den beiden Außenseiten 30 ° beträgt.
Alle Elemente des Seilantriebes bestehen aus Titan und das Seil aus Edelstahllitze.

## Patentansprüche

1. Kippbare Seilantriebseinheit für Kryomanipulatoren, bestehend aus mindestens zwei Seilrädern von denen mindestens ein Seilrad aus einem Außenring, der eine Innenverzahnung aufweist, und aus einem Innenring, der mit einer Welle fest verbunden ist, die eine zentrale Bohrung zur Heranführung eines Kältezuführungsstranges für die Kühlung von Probe und Probenhalterung aufweist, und eine Außenverzahnung aufweist, die in die Innenverzahnung des Außenrings passt, besteht, wobei die Aussparungen der Innenverzahnung des Außenrings über die gesamte Höhe des Außenringes einen im wesentlichen unveränderten rechteckigen Querschnitt aufweisen und die auf dem Innenring hervorstehenden Zähne der Außenverzahnung des Innenringes mit ihrem größten Querschnitt mindestens in die Aussparungen der Innenverzahnung des Außenringes passen und die Zähne der Außenverzahnung des Innenringes über die Höhe des Innenringes eine veränderliche Breite aufweisen, die in der Mitte der Höhe des Innenringes am größten ist und höchstens der maximalen Breite der Aussparungen im Außenring entspricht, und die Breite der Zähne mit der Entfernung von der Mitte der Höhe geringer wird und der Winkel der Zahnflanken zwischen maximaler und minimaler Breite der Zähne maximal 30 ° beträgt, und weiterhin entweder nur der Außenring oder der Innenring gelagert ist und dann der Innenring oder der Außenring durch Formschluss, im Außenring oder im Innenring geführt, gelagert und gehalten ist.

2. Seilantriebseinheit nach Anspruch 1, bei der der Außen- und/oder der Innenring aus Metall besteht.

3. Seilantriebseinheit nach Anspruch 1, bei der der Außen- und /oder Innenring aus einem nichtmagnetischen Material bestehen.

4. Seilantriebseinheit nach Anspruch 1, bei der die Veränderung der Breite der Zähne von ihrer Mitte nach beiden Seiten hin kontinuierlich geringer ist.

5. Seilantriebseinheit nach Anspruch 1, bei der die Veränderung der Breite der Zähne von der Mitte des Innenrings aus über die gesamte Höhe des Innenringes erfolgt.

6. Seilantriebseinheit nach Anspruch 1, bei der die Bewegung des seilangetriebenen Außenrings über den Innenring auf die damit fest verbundene Welle übertragen ist.

7. Seitantriebseinheit nach Anspruch 1, bei der der Innenring innerhalb des Außenringes in einem Winkel von insgesamt maximal 60 ° gegenüber der gemeinsamen Mittelachse kippbar ist.

8. Seilantriebseinheit nach Anspruch 1, bei der eine zentrale Bohrung zur Heranführung eines Kältezuführungsstranges für die Kühlung von Probe und Probenhalterung vorhanden ist.

9. Seilantriebseinheit nach Anspruch 8, bei der die zentrale Bohrung einen größtmöglichen Durchmesser aufweist.

10. Seilantriebseinheit nach Anspruch 1, bei der der Außenring getrennt vom Innenring gelagert ist.

11. Seilantriebseinheit nach Anspruch 1, bei der die Dicke des Außenringes B im Verhältnis zum seinem Außendurchmesser Dₐ gering ist.

12. Seilantriebseinheit nach Anspruch 11, bei der das Verhältnis Dₐ / B ≥ 5 ist.

## Claims

1. Tiltable cable drive unit for cryomanipulators, consisting of at least two cable wheels, at least one cable wheel of which consists of an outer ring, which has an internal toothing, and of an inner ring, which is fixedly connected to a shaft, having a central bore for feeding a cold-supply string for cooling a specimen and specimen holder, and has an external toothing which fits into the internal toothing of the outer ring, the clearances of the internal toothing of the outer ring having an essentially unchanged rectangular cross section over the entire height of the outer ring, and the teeth, projecting on the inner ring, of the external toothing of the inner ring fitting with their largest cross section at least into the clearances of the internal toothing of the outer ring, and the teeth of the external toothing of the inner ring having over the height of the inner ring a variable width which is greatest in the middle of the height of the inner ring and corresponds at most to the maximum width of the clearances in the outer ring, and the width of the teeth becoming smaller with the distance from mid-height, and the angle of the tooth flank between the maximum and the minimum width of the teeth amounting to at most 30°, and, furthermore, either only the outer ring or the inner ring is mounted, and then the inner ring or the outer ring is guided, mounted and held in the outer ring or in the inner ring by form fit.

2. Cable drive unit according to Claim 1, in which the outer ring and/or the inner ring consist/consists of metal.

3. Cable drive unit according to Claim 1, in which the outer ring and/or the inner ring consist/consists of a non-magnetic material.

4. Cable drive unit according to Claim 1, in which the variation in the width of the teeth is continuously smaller from their middle towards both sides.

5. Cable drive unit according to Claim 1, in which the variation in the width of the teeth takes place from the middle of the inner ring over the entire height of the inner ring.

6. Cable drive unit according to Claim 1, in which the movement of the cable-driven outer ring is transmitted via the inner ring to the shaft connected fixedly thereto.

7. Cable drive unit according to Claim 1, in which the inner ring is tiltable within the outer ring at an angle of overall at most 60° with respect to the common mid-axis.

8. Cable drive unit according to Claim 1, in which a central bore for feeding a cold-supply string for cooling a specimen and specimen holder is present.

9. Cable drive unit according to Claim 8, in which the central bore has the largest possible diameter.

10. Cable drive unit according to Claim 1, in which the outer ring is mounted separately from the inner ring.

11. Cable drive unit according to Claim 1, in which the thickness of the outer ring B is small in relation to its outside diameter Dₐ.

12. Cable drive unit according to Claim 11, in which the ratio is Dₐ/B ≥ 5.

## Revendications

1. Unité d'entraînement par câble basculante pour cryomanipulateurs, composée d'au moins deux roues à câble, dont au moins une roue à câble se compose d'une bague extérieure qui présente une denture intérieure et d'une bague intérieure qui est connectée fixement à un arbre, qui présente un alésage central pour guider une chaine de transfert de froid pour le refroidissement d'échantillons et pour le maintien des échantillons, et qui présente une denture extérieure, laquelle est adaptée dans la denture intérieure de la bague extérieure, les évidements de la denture intérieure de la bague extérieure présentant une section transversale rectangulaire essentiellement inchangée sur toute la hauteur de la bague extérieure et les dents de la denture extérieure de la bague intérieure, saillant sur la bague intérieure, s'adaptant avec leur plus grande section transversale au moins dans les évidements de la denture intérieure de la bague extérieure et les dents de la denture extérieure de la bague intérieure présentant une largeur variable sur toute la hauteur de la bague intérieure, cette largeur étant maximale au milieu de la hauteur de la bague intérieure et correspondant au maximum à la largeur maximale des évidements dans la bague extérieure, et la largeur des dents devenant de plus en plus petite au fur et à mesure que l'on s'éloigne du centre de la hauteur et l'angle des flancs des dents étant au maximum de 30° entre la largeur maximale et la largeur minimale des dents, et en outre soit seulement la bague extérieure soit seulement la bague intérieure étant montée sur palier puis la bague intérieure ou la bague extérieure étant guidée, montée sur palier et retenue par engagement par coopération de forme dans la bague extérieure ou dans la bague intérieure.

2. Unité d'entraînement par câble selon la revendication 1 dans laquelle la bague extérieure et/ou la bague intérieure se composent de métal.

3. Unité d'entraînement par câble selon la revendication 1 dans laquelle la bague extérieure et/ou la bague intérieure se composent d'un matériau non magnétique.

4. Unité d'entraînement par câble selon la revendication 1 dans laquelle la variation de largeur des dents depuis leur milieu vers les deux côtés diminue de manière continue.

5. Unité d'entraînement par câble selon la revendication 1, dans laquelle la variation de largeur des dents a lieu depuis le milieu de la bague intérieure sur toute la hauteur de la bague intérieure.

6. Unité d'entraînement par câble selon la revendication 1, dans laquelle le mouvement de la bague extérieure entraînée par câble est transmis par le biais de la bague intérieure à l'arbre qui lui est connecté fixement.

7. Unité d'entraînement par câble selon la revendication 1, dans laquelle la bague intérieure peut basculer à l'intérieur de la bague extérieure suivant un angle de 60° au maximum au total par rapport à l'axe médian commun.

8. Unité d'entraînement par câble selon la revendication 1, dans laquelle un alésage central est prévu pour guider une chaine de transfert de froid pour le refroidissement d'échantillons et pour le maintien des échantillons.

9. Unité d'entraînement par câble selon la revendication 8, dans laquelle l'alésage central présente un diamètre aussi grand que possible.

10. Unité d'entraînement par câble selon la revendication 1, dans laquelle la bague extérieure est montée de manière séparée de la bague intérieure.

11. Unité d'entraînement par câble selon la revendication 1, dans laquelle l'épaisseur de la bague extérieure B est faible par rapport à son diamètre extérieur Dₐ.

12. Unité d'entraînement par câble selon la revendication 11, dans laquelle le rapport Dₐ /B≥5.
